# EUROPÄISCHE PATENTSCHRIFT

(11) **EP 0 931 351 B1**
(45) Veröffentlichungstag und Bekanntmachung des Hinweises auf die Patenterteilung: **28.01.2004**
(21) Anmeldenummer: 97910230.8
(22) Anmeldetag: 29.09.1997
(51) Int. Cl.: H01L 29/74, H01L 29/32, H01L 29/10

(54) **THYRISTOR MIT DURCHBRUCHBEREICH**
THYRISTOR WITH BREAKDOWN REGION
THYRISTOR AVEC ZONE DE CLAQUAGE

(30) Priorität: 30.09.1996 DE 19640313; 06.12.1996 DE 19650762
(43) Veröffentlichungstag der Anmeldung: 28.07.1999
(73) Patentinhaber: EUPEC Europäische Gesellschaft für Leistungshalbleiter mbH & Co. KG, 59581 Warstein-Belecke (DE)
(72) Erfinder: RUFF, Martin, D-85591 Vaterstetten (DE); SCHULZE, Hans-Joachim, D-85521 Ottobrunn (DE)
(74) Vertreter: Schmuckermaier, Bernhard
(86) Internationale Anmeldenummer: PCT/DE1997/002237
(87) Internationale Veröffentlichungsnummer: WO 1998/015010

(56) Entgegenhaltungen:
- EP-A- 0 423 721
- EP-A- 0 572 826
- WO-A-92/17907

## Beschreibung

Die Erfindung betrifft einen Thyristor, bestehend aus einem Halbleiterkörper
- mit einer anodenseitigen Basiszone vom ersten Leitungstyp und mindestens einer katodenseitigen Basiszone vom entgegengesetzten, zweiten Leitungstyp,
- mit anodenseitigen und katodenseitigen Emitterzonen,
- mit mindestens einem Bereich in der katodenseitigen Basiszone, der durch seine Geometrie eine gegenüber den übrigen Bereichen in der katodenseitigen Basiszone und dem Rand des Halbleiterkörper verminderte Durchbruchspannung aufweist,

In Hochspannungsanlagen sind im allgemeinen mehrere Thyristoren in Reihe geschaltet. Diese müssen stets gleichzeitig gezündet werden. Zündet einer der Thyristoren später, so liegt an ihm nahezu die gesamte Spannung an und der Thyristor wird zerstört. Man ist daher bemüht, Thyristoren zu entwickeln, die "über Kopf" gezündet werden können. Solche Thyristoren haben in der Regel einen zentralen Bereich, der eine gegenüber dem übrigen Bereich und dem Rand niedrigere Durchbruchsspannung hat. Steigt die Spannung am Thyristor an, so geht dieser Bereich in den Lawinendurchbruch und der Durchbruchstrom kann den Thyristor direkt oder über einen oder mehrere Hilfsthyristorstrukturen zünden.

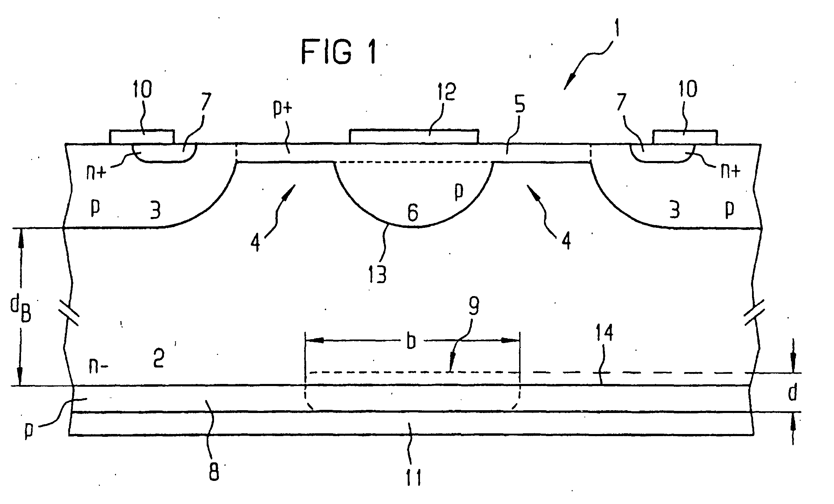

Der Durchbruchbereich kann zum Beispiel dadurch erzeugt werden, daß die kathodenseitige Basiszone eine Aussparung hat, innerhalb der an der Oberfläche des Halbleiterkörpers eine dünnere Schicht des gleichen Leitungstyps angeordnet ist. Der pn-Übergang zwischen der anoden- und kathodenseitigen Basiszone hat dann beim Übergang von der Waagerechten in die Aussparung einen definierten Krümmungsradius, an dem eine gegenüber einem ebenen pn-Übergang höhere Feldstärke auftritt. An der Krümmung kommt es daher vorzugsweise zu einem Durchbruch des Thyristors. Eine gattungsgemäße Struktur ist zum Beispiel in dem Artikel "Design consideration for high-power, overvoltage self-protected thyristor" von Ohashi, Yoshida, Yamaguchi, Akagi, veröffentlicht in IPEC-Tokyo 1983, Seiten 550-558, insbesondere anhand von Figur 1b beschrieben worden.

Die Durchbrucheigenschaften des genannten Bereichs hängen von der Form des pn-Übergangs der katodenseitigen Basiszone ab. In DE 42 15 378 C1 (≅ EP-0 572 826 A1) ist ein weiterer gattungsgemäßer Thyristor mit Bereichen verminderter Durchbruchspannung angegeben. Diese Bereiche verminderter Durchbruchspannung sind sehr wirksam und gut reproduzierbar.

Dort ist die Überkopfzündspannung von Thyristoren mit integriertem Überspannungsschutz jedoch stark temperaturabhängig. Gründe hierfür sind zum einen die mit der Temperatur zunehmende Durchbruchspannung und die mit der Temperatur steigende Emitter-Kollektor-Verstärkung αₚₙₚ. Bei hohen Temperaturen verstärkt die Transistorverstärkung αₚₙₚ den Sperrstrom in der Weise, daß es zur vorzeitigen Zündung des Thyristors bei niedrigeren Überkopfzündspannung als vorgesehen kommt. Dies kann zum unbeabsichtigten vorzeitigen Zünden des Thyristors führen.

In der EP-A-423 721 ist ein Thyristor beschrieben, der einen verformten Bereich mit einer Rekombinationszone aufweist. Dieser verformte Bereich weist-aufgrund seiner Geometrie eine verminderte Durchbruchspannung auf. Weitere gattungsgemäße als Thyristor ausgebildete Halbleiterbauelemente mit verminderter Durchbruchspannung sind in der WO 92/17907 sowie in der EP-8-572 826 beschrieben.

Der vorliegenden Erfindung liegt daher die Aufgabe zugrunde, einen Thyristor der eingangs genannten Art derart weiterzubilden, daß die Überkopfzündspannungen des Thyristors im Temperaturbereich des Thyristorbetriebs weitgehend temperaturunabhängig ist.

Die Aufgabe wird gelöst durch den kennzeichnenden Teil des Patentanspruchs 1. Insbesondere sind hier anodenseitig unterhalb der Zone verminderter Durchbruchspannung Rekombinationszentren vorgesehen, die die Lebensdauer der freien Ladungsträger herabsetzen.

Die Ausgestaltung der Rekombinationszone ist Bestandteil der Patentansprüche 2 bis 6. Die Rekombinationszone besteht dabei im wesentlichen aus Defekten, die durch Bestrahlung mit nichtdotierenden, hochenergetischen Teilchen erzeugt werden. Bei den Defekten handelt es sich üblicherweise um Frenkel-Defekte beziehungsweise Schottky-Defekte, die bei Bestrahlung des Halbleiterkörpers mit α-Teilchen oder Protonen erzeugt werden. Es sind aber auch andere Defekte denkbar. Für die Bestrahlung wird eine relativ geringe Dosis von 10¹⁰ bis 10¹² cm⁻² angesetzt, da der Kristall durch die Bestrahlung nicht zu stark geschädigt werden soll.

Die Patentansprüche 7 und 8 spezifizieren die Geometrie der Thyristorstrükturen, insbesondere der Zonen mit verminderter Durchbruchspannung. Die kathodenseitigen Basis- und Emitterbereiche sind vorteilhafterweise in der Ebene der Oberfläche kreisförmig ausgebildet und bilden einen Ringthyristor.

In einer Weiterbildung gemäß Patentanspruch 9 ist an der Oberfläche zwischen der Basiszone und dem Bereich verminderter Durchbruchspannung eine weitere Zone vorgesehen, welche die Oberfläche des Thyristors vor Oberflächenladungen schützt. Diese Zone ist entsprechend höher dotiert als die Basiszone und die Zone verminderter Durchbruchspannung.

Patentanspruch 15 ist auf ein bevorzugtes Verfahren zur Herstellung der erfindungsgemäßen Rekombinationszone gerichtet.

Die Erfindung wird anhand der in den Figuren der Zeichnung dargestellten Ausführungsbeispiele näher erläutert. Es zeigt:
- Figur 1: einen Teilschnitt eines erfindungsgemäßen Thyristors mit anodenseitiger Rekombinationszone;
- Figur 2: die Überkopfzündkennlinie für eine Thyristor
(a) ohne Rekombinationszone (nach DE 42 15 378 C1)
(b) und mit Rekombinationszone an der Scheibenrückseite.
- Figur 3: einen lichtzündbaren Thyristor mit integriertem BOD- und dU/dt-Schutz im Querschnitt;
- Figur 4: die dem Überspannungssschutz dienende BOD-Struktur des Thyristors gemäß Figur 3;
- Figur 5: die mit Hilfe eines Simulationsprogramms berechnete Temperaturabhängigkeit der BOD-Spannung für drei unterschiedlich aufgebaute Thyristoren.

### 1. Ausführungsbeispiel

Figur 1 zeigt einen Teilschnitt durch einen erfindungsgemäßen Thyristor. Ein Halbleiterkörper 1, beispielsweise eine Siliziumscheibe, enthält eine n⁻-dotierte anodenseitige Basiszone 2. Katodenseitig schließt sich eine p-dotierte Basiszone 3 an. Die Basiszone 3 enthält eine Aussparung 4. In der Aussparung 4 ist an der Oberfläche des Halbleiterkörpers 1 eine dünne p+-dotierte Schicht 5 angeordnet, die mit der Basiszone 3 verbunden ist . In der Aussparung 4 ist außerdem eine zusätzliche Zone 6 des gleichen Leitungstyps wie die katodenseitige Basiszone 3 angeordnet. Die zusätzliche Zone 6 ist mit der dünnen Schicht 5 verbunden und hat allseitig einen Abstand vom Rand der Aussparung 4, d.h. von der Basiszone 3. Die zusätzliche Zone 6 hat die Form eines Kugelschnittes, wobei die Schnittebene an die dünne Schicht 5 angrenzt. Vorzugsweise ist die dünne Schicht 5 sehr viel höher. dotiert als die Basiszone 3 und die zusätzliche Zone 6. Die Form der Bereiche 4, 5, 6 ist aber nicht zwingend. Wesentlich ist jedoch, daß die zusätzliche Zone 6 von der Innenzone 2 gesehen mindestens teilweise konkav ist. Durch seine Form weist die zusätzliche Zone 6 eine gegenüber den übrigen Bereichen in der katodenseitigen Basiszone 3 und dem Rand des Halbleiterkörper 1 verminderte Durchbruchspannung auf.

Kathodenseitig sind in der Basiszone 3 n⁺-dotierte Emitterzonen 7 eingebettet, die beispielsweise die Hilfsemitterzonen von Hilfsthyristoren sein können. Die Emitterzonen 7 werden durch Emitterelektroden 10 kontaktiert. Außerdem kontaktieren die Emitterelektroden 10 an der Außenseite auch die Basiszone 3. Die dünne Schicht 5 wird im Bereich der zusätzlichen Zone 6 an der Oberfläche von einer Gateelektrode 12 kontaktiert.

Vorzugsweise sind die katodenseitige Basiszone 3 und die Emitterzone 7 sowie die dünne Schicht 5 und die zusätzliche Zone 6 in der Ebene der Oberfläche des Halbleiterkörpers 1 kreisförmig oder kreisringförmig ausgebildet. Der erfindungsgemäße Thyristor ist vorzugsweise ein Ringthyristor. Die dargestellten Formen der oben genannten Zonen und Schichten 3, 5, 6, 7 ist jedoch nicht zwingend. Sie können auch von der Kreisform bzw. Kreisringform abweichen und beispielsweise polygonal ausgeformt sein.

Die oben beschriebenen Zonen bzw. Schichten können entsprechend DE 42 15 378, insbesondere Figur 1, ausgebildet sein. In DE 42 15 378 C1 ist ein Thyrister mit integriertem Überspannungsschutz angegeben. Bei Anlegen einer Spannung in Flußrichtung werden bevorzugt im Bereich des pn-Übergangs 13 der zusätzlichen Zone 6 Ladungsträgerpaare gebildet, von denen sich die Elektronen zur anodenseitigen Emitterzone 8 und die Löcher zur dünnen Schicht 5 und dann über die Basiszone 3 zur Emitterelektrode bewegen. Dieser Strom verstärkt sich lawinenartig und leitet auf bekannte Weise die Zündung des Thyristors ein. Die zusätzliche Zone 6 bildet damit einen durch ihre Geometrie vorgegebenen Bereich mit verminderter Durchbruchspannung. Die dünne Schicht 5 hat die Aufgabe, die kathodenseitige Oberfläche des Thyristors vor Oberflächenladungen zu schützen. Zu diesem Zweck ist sie, wie bereits erwähnt, höher dotiert als die zusätzliche Zone 6 und die Basiszone 3. In DE 42 15 378 C1 ist außerdem ein bevorzugtes Verfahren zur Herstellung der oben beschriebenen Thyristorstruktur angegeben.

Anodenseitig ist außerdem in dem unterhalb der zusätzlichen Zone 6 liegenden Bereich des Halbleiterkörpers 1 eine Rekombinationszone 9 vorgesehen. Die Rekombinationszone 9 wird durch anodenseitige Bestrahlung des Halbleiterkörpers 1 mit nichtdotierenden, hochenergetischen Teilchen, insbesondere α-T eilchen oder Protonen, erzeugt. Durch die Bestrahlung werden anodenseitig Defekte im Kristallgitter erzeugt. Bei den Defekten handelt es sich insbesondere um Frenkel-Defekte und/oder Schottky-Defekte, wobei auch andere Defekte denkbar sind. Die räumliche Verteilung dieser Defekte definiert die Rekombinationszone 9.

Die vertikale Lage der Zone 9 im Halbleiterkörper 1 ist so gewählt, daß die dem pn-Übergang 13 zugeordnete Raumladungszone den geschädigten Bereich auch beim Anliegen der-durch die zentrale BOD-Struktr 4/5/6 vorgegebenen maximalen Blokkierspannung U_{BOD} nicht erreicht. Dies ist gewährleistet, wenn die strahlungsinduzierten Rekombinationszentren vorwiegend in der anodenseitigen Emitterzone 8 lokalisiert sind, die Rekombinationszone 9 also nicht oder nur unwesentlich in die anodenseitige Basiszone 2 hineinreicht. Im gezeigten Ausführungsbeispiel beträgt die Dicke d der Rekombinationszone 9 beispielsweise d ≤ 150 µm, während der die anodenseitige Basiszone 2 und die anodenseitige Emitterzone 8 trennende pn-Übergang 14 in einer Tiefe von typischerweise 70-100 µm liegt. Die in lateraler Richtung gemessene Breite b der Rekombinationszone 9 sollte etwa dem 1-2-Fachen der Dicke d_{B} der anodenseitigen Basiszone 2 entsprechen, also etwa b ≈ 1-4 mm betragen.

Für die Bestrahlung wird eine niedrige Bestrahlungsdosis gewählt, da der Halbleiterkörper 1 durch die Bestrahlung nicht zu stark geschädigt werden soll. Die Bestrahlungsdosis liegt typischerweise im Bereich von etwa 10¹⁰ bis 10¹² cm⁻² bei Bestrahlung mit α-Teilchen und von 10¹¹ bis 10¹³ cm⁻² bei Bestrahlung mit Protonen.'Die Bestrahlungsenergie kann je nach gewünschter Lage der Rekombinationszone 9 in der anodenseitigen p-Emitterzone 8 bzw. n⁻-Basiszone 2 zwischen 5 und 20 MeV gewählt werden. Ist eine stärkere Schädigung des Kristalls erforderlich, können auch schwerere Teilchen wie zum Beispiel Sauerstoffionen zur Bestrahlung verwendet werden. Als Bestrahlungsquelle wird üblicherweise ein Hochenergieionenimplanter verwendet.

Nach der Bestrahlung wird üblicherweise ein Temperschritt (zum Beispiel 220 °C, 20 h) zur Stabilisierung der Rekombinationszent ren 9 durchgeführt. Durch eine anodenseitige Maske kann der Bestrahlungsbereich gewählt werden. Da es sich hier meist um sehr große Strukturen handelt, kann als Maske beispielsweise eine Metallochblende dienen.

Nachfolgend wird die Funktion der erfindungsgemäßen Thyristorstruktur erläutert.

Durch die anodenseitig eingebrachten hochenergetischen Teilchen in der Rekombinationszone 9 wird im Halbleiterkörper 1 ein vertikal inhomogenes Lebensdauerprofil erzeugt. In der Rekombinationszone 9 ist die Mayoritätsladungsträgerlebensdauer im Vergleich zu den übrigen Bereichen stark reduziert. Die reduzierte Lebensdauer bewirkt eine verstärkte Rekombination der Ladungsträger und damit eine Verringerung der Transistorverstärkung αₚₙₚ, insbesondere bei hohen Temperaturen. Dadurch kann die starke Abnahme der Überkopfzündspannung zu höheren Temperaturen hin verschoben werden. Diese Temperaturverschiebung läßt sich sowohl durch die Stärke der zusätzlichen Lebensdauerabsenkung als auch durch deren Lage beeinflussen.

Thyristoren der genannten Art können entweder über eine Gateelektrode 12 stromgesteuert oder lichtgesteuert sein.

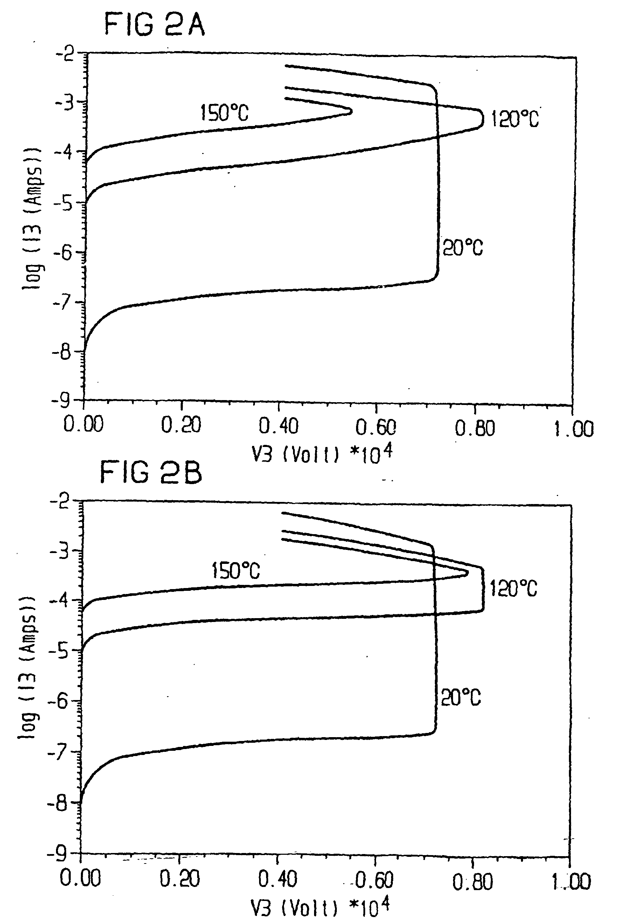

Figur 2 zeigt die simulierte Strom-Spannungs-Kennlinie bei Überkopfzündung eines Thyristors nach DE 42 15 378 (a) im Vergleich zur erfindungsgemäßen Thyristorstruktur mit anodenseitiger Rekombinationszone (b) bei verschiedenen Temperaturen. In Figur 2 (b) erkennt man, daß durch die Trägerlebensdauerabsenkung in der Rekombinations zone 9 die Überkopf zündspannung der Thyristoren im Vergleich zu (a) deutlich temperaturstabiler sind. Durch die gewählten Maßnahmen ist damit die Überkopfzündspannung der erfindungsgemäßen Thyristoren bis etwa 140°C weniger temperaturabhängig. Im Bereich der zulässigen Betriebstemperaturen verliert der Thyristor damit nicht seine Blockierfähigkeit.

### 2. Ausführungsbeispiel

Der oben beschriebene Thyristor zündet bereits vor dem Erreichen der durch die zentrale BOD-Struktur 4/5/6 vorgegebenen statischen Kippspannung U_{BOD}, wenn die zeitliche Änderung dU/dt der angelegten Blockierspannung U einen kritischen Wert von mehreren kV/µs übersteigt. Ausgelöst wird diese unter Umständen zur Zerstörung des Thyristors führende Fehlzündung durch den Aufbau der Raumladungszone am p-Basis/n-Basis-Übergang 13 und dem daraus resultierenden, den Sperrstrom verstärkenden Verschiebungsstrom I_{d} = C_{d} x dU/dt (C_{d}: spannungsabhängige Raumladungskapazität des pn-Übergangs 13). Durch Einbau einer Zone erhöhten Widerstandes in die kathodenseitige Basis 3 unterhalb des ersten Hilfsthyristors 7/10 läßt sich die durch eine-zu große dU/dt-Belastung hervorgerufene Fehlzündung gezielt in den Zentralbereich des Thyristors verlagern. Da das von der Zündung betroffene Volumen dann innerhalb des vom ersten Hilfsthyristor 7/10 begrenzten Bereichs liegt, kann sich das Plasma, wie bei einer gesteuerten Zündung, großflächig und gleichförmig in radialer Richtung ausbreiten, ohne daß die Stromdichte kritische Werte erreicht (s. beispielsweise die Veröffentlichung von H.-J. Schulze et al. in Proceedings of the ISPSD 96, 197, Hawai 1996).

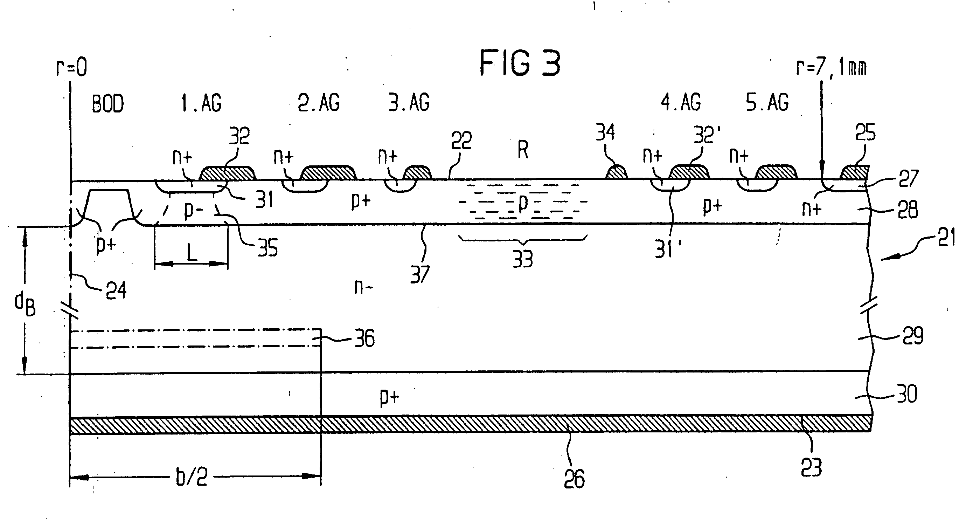

Die Figur 3 zeigt einen lichtzündbaren Thyristor mit integriertem dU/dt-Schutz im Querschnitt. Er ist rotationssymmetrisch bezüglich der senkrecht auf den beiden Hauptflächen 22/23 des Halbleiterkörpers 21 stehenden Achse 24 aufgebaut. Während die obere Hauptfläche 22 des scheibenförmigen Halbleiterkörpers 21 die randseitig verlaufende, mit Emitterkurzschlüssen versehene Kathodenmentallisierung 25 trägt, ist seine rückseitige Hauptfläche 23 vollständig mit einer als Anode dienenden Metallisierung 26 beschichtet. Der aus Silizium bestehende Halbleiterkörper 21 weist mehrere, unterschiedlich dotierte, jeweils durch Raumladungszonen voneinander getrennte Bereiche 27-30 auf. Diese Bereiche unterschiedlicher Leitfähigkeit bilden den n⁺-dotierten, kathodenseitigen Emitter 27, die p-dotierte Basis 28, die nur schwach elektronenleitende, anodenseitige Basis 29 sowie den von der Anodenmetallisierung 26 kontaktierten p⁺-Emitter 30.

Die mit AG (Amplyfing Gate) bezeichneten, radial innerhalb der Kathodenmetallisierung 25 angeordneten Hilfsthyristoren 1.-5.-AG bilden die Treiberstufen des Hauptthyristors. Sie weisen jeweils einen in der kathodenseitigen Basis 28 eingebetteten, n⁺-dotierten Hilfsemitter 31/31' und eine sowohl den Hilfsemitter 31/31' als auch die Basis 28 kontaktierende Metallisierung 32/32' auf. In einer die innersten drei Hilfsthyristoren 1.-3.-AG ringförmig umschließenden Zone 33 ist die Dotierstoffkonzentration gegenüber den lateral angrenzenden Bereichen der kathodenseitigen Basis 28 verringert. Diese Ringzone 33 wirkt als Widerstand R, der den in der Basis 28 radial nach außen fließenden Zündstrom auf einen vorgegebenen Maximalwert begrenzt und so die Belastung der Struktur während der Einschaltphase vermindert.

Um die durch eine zu große dU/dt-Belastung hervorgerufene Zündung gezielt in den Zentralbereich des Thyristors zu verlagern, besitzt die kathodenseitige Basis 28 in einer unterhalb des n⁺-dotierten Bereichs 31 des ersten Hilfsthyristors 1.-AG liegenden Ringzone 35 einen erhöhten Widerstand. Da die Breite L und der durch die Dotierstoffkonzentration gegebene Schichtwiderstand R_{□} der Ringzone 35 sowohl die zur Zündung des ersten Hilfsthyristors 1.-AG erforderliche minimale Strahlungsintensität als auch dessen dU/dt-Belastbarkeit entscheidend beeinflußt, läßt sich durch eine geeignete Dimensionierung dieser Parameter sicherstellen, daß die zentral gelegene Thyristorstruktur die größte dU/dt-Empfindlichkeit des Systems aufweist und sie demzufolge bei Überschreitung eines kritischen Wertes der Spannungssteilheit dU/dt zuerst zündet. Der Schichtwiderstand R_{□} der etwa 200-600 µm breiten Ringzone 35 beträgt typischerweise R_{□} = 2000-5000 Ω_{□} . Er ist damit um einen Faktor 10-20 größer als der Schichtwiderstand des angrenzenden Basisbereichs (R_{□}(p⁺) ≈ 200 - 400 Ω_{□} ).

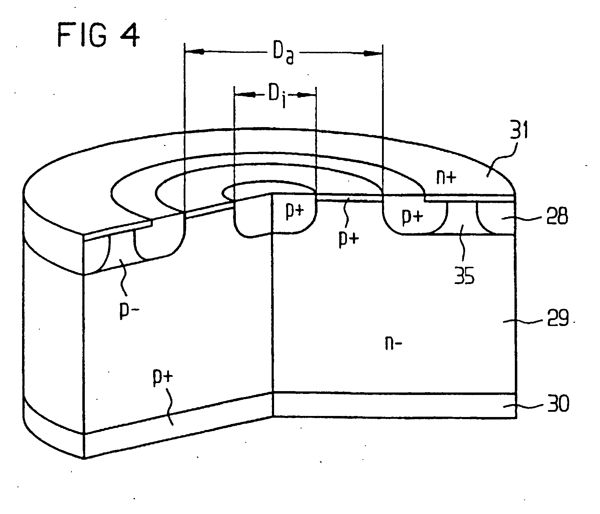

Die oben bereits beschriebene, in Figur 4 vergrößert dargestellte BOD-Struktur des Thyristors dient dem Überspannungsschutz. Ihre lateralen Abmessungen sind mit Dᵢ = 350 µm und Dₐ = 550 µm so bemessen, daß die Durchbruchspannung U_{BOD} bei Zimmertemperatur T = 23°C etwa U_{BOD} ≈ 7, 8 kV beträgt .

Um die durch die Geometrie der BOD-Struktur vorgegebene Spannung U_{BOD} ("Überkopfzündspannung") insbesondere bei höheren Betriebstemperaturen T ≥ 80-90°C weitgehend konstant zu halten, weist die anodenseitige Basis 29 in ihrem zentralen Bereich unterhalb der BOD-Struktur eine vertikal inhomogene Verteilung der Dichte strahlungsinduzierter Gitterdefekte auf. Die Lage dieser vergleichsweise schmalen, etwa 20 µm breiten Zone 36 im Halbleiterkörper 21, d. h. ihr vertikaler Abstand von der anodenseitigen Hauptfläche 23 ist hierbei derart gewählt, daß die dem pn-Übergang 37 zugeordnete Raumladungszone den geschädigten Bereich 36 bei einer Blokkierspannung U ≤ U_{BOD} von etwa U ≈ 8,2 kV erreicht. Steigt die Blockierspannung U nur unwesentlich weiter an, liegt der geschädigte Bereich 36 vollständig innerhalb der Raumladungszone, wobei die strahlungsinduzierten Defekte nun nicht mehr als Rekombinationszentren, sondern als Generationszentren freier Ladungsträger wirken. Der zum Sperrstrom beitragende und exponentiell mit der Temperatur anwachsende Generationsstrom in der Raumladungszone vergrößtert den Verstärkungsfaktor αₚₙₚ der durch die Schichten 28/29/30 gebildeten Transistorstruktur soweit, daß der Thyristor bei einer nur unwesentlich von der gewünschten Durchbruchsspannung U_{BOD} abweichenden Blockierspannung zündet. Die vertikal inhomogene Verteilung der Defektdichte in der anodenseitigen Basis 29 erzeugt man wieder durch eine Bestrahlung des Halbleiterkörpers 21 mit Protonen oder Heliumkernen. Außer dem schon beschriebenen Verfahren können insbesondere auch die aus der WO 92/17907 bekannten Bestrahlungstechniken zur Anwendung kommen. Der Abstand b_{D}/2 des Randes der Zone 36 von der Symmetrieachse 24 beträgt typischerweise b_{D}/2 ≤ (1-2) d_{B}, wobei d_{B} = 1-2 mm die Breite der anodenseitigen Basis 29 bezeichnet.

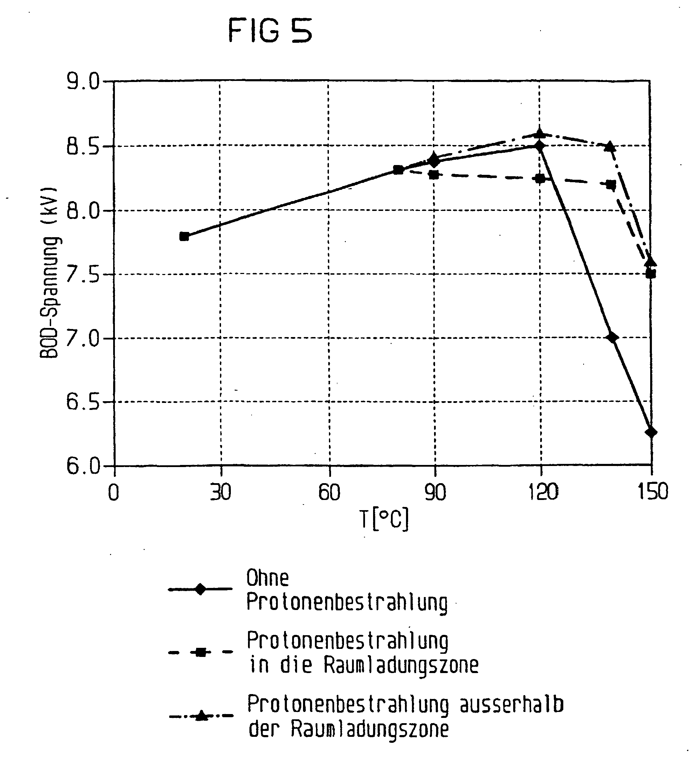

In Figur 5 ist die mit Hilfe eines Simulationsprogramms berechnete Temperaturabhängigkeit der Überkopfzundspannung U_{BOD} verschiedener Thyristoren dargestellt. Wie erwartet, steigt die Spannung U_{BOD} des nicht mit Protonen bestrahlten Thyristors aufgrund des positiven Temperaturkoeffizienten der Avalanche-Koeffizienten zunächst mit der Temperatur T kontinuierlich an, um ab einer Temperatur T ≈ 120°C schließlich steil abzufallen (negativer Temperaturkoeffizient der Transistorverstärkung αₚₙₚ als Folge des erhöhten Sperrstromes). Das Temperaturverhalten der BOD-Spannung verbessert sich deutlich, wenn der Thyristor im anodenseitigen Emitter eine durch Bestrahlung mit Protonen erzeugte Zone abgesenkter Lebensdauer aufweist (s. die als Dreiecke dargestellten Simulationswerte). Ähnlich verhält sich die BOD-Spannung eines Thyristors, bei dem die Zone abgesenkter Lebensdauer in der anodenseitigen Basis an einer Stelle lokalisiert ist, die die dem pn-Übergang 37 zugeordnete Raumladungszone, unabhängig von der anliegenden Blockierspannung, nicht erreicht. Die BOD-Spannung bleibt im Temperaturbereich 80°C ≤ T ≤ 140°C annähernd konstant, falls die Zone erhöhter Defektdichte beim Anliegen der gewünschten Blockierspannung von beispielsweise U_{BOD} ≈ 8,2 kV innerhalb der vom p-Basis/n-Basis-Übergang 37 ausgehenden Raumladungszone liegt (s. die als Quadrate dargestellten Simulationswerte).

## Patentansprüche

1. Thyristor bestehend aus einem Halbleiterkörper (1)
- mit einer anodenseitigen Basiszone (2) vom ersten Leitungstyp und mindestens einer katodenseitigen Basiszone (3) vom entgegengesetzten, zweiten Leitungstyp,
- mit anodenseitigen und katodenseitigen Emitterzonen (7,8),
- mit mindestens einem Bereich (4, 5, 6) in der katodenseitigen Basiszone (3), der durch seine Geometrie eine gegenüber den übrigen Bereichen in der katodenseitigen Basiszone (3) und dem Rand des Halbleiterkörper (1) verminderte Durchbruchspannung aufweist,
**dadurch gekennzeichnet,**
**daß** anodenseitig unterhalb des Bereichs verminderter Durchbruchspannung (6) mindestens eine Rekombinationszone (9) mit verminderter Lebensdauer der freien Ladungsträger vorgesehen ist und daß die Geometrie der katodenseitigen Bereiche (4, 5, 6) im wesentlichen folgende Merkmale aufweist:
- eine Aussparung (4) ist im zentralen Bereich der kathodenseitigen Basiszone (3) angeordnet, innerhalb der an der Oberfläche des Halbleiterkörpers (1) eine gegenüber der kathodenseitigen Basiszone (3) dünnere Schicht (5) des zweiten Leitungsytyps angeordnet ist, welche mit der katodenseitigen Basiszone (3) verbunden ist,
- in der Aussparung (4) ist eine zusätzliche Zone (6) des zweiten Leitungstyps angeordnet, die an die dünne Schicht (5) angrenzt,
- die zusätzliche Zone (6) ist von der kathodenseitigen Basiszone (3) aus gesehen mindestens teilweise konkav ausgebildet.

2. Thyristor nach Anspruch 1,
**dadurch gekennzeichnet,**
**daß** die Rekombinationszone (9) durch Bestrahlung erzeugte Kristallgitterdefekte aufweist.

3. Thyristor nach Anspruch 2,
**dadurch gekennzeichnet,**
**daß** die Kristallgitterdefekte Frenkel-Defekte und/oder Schottky-Defekte sind.

4. Thyristor nach einem der Ansprüche 1 - 3,
**dadurch gekennzeichnet,**
**daß** die katodenseitigen Bereiche (4, 5, 6) sowie die kathodenseitige Basiszone (3) und die katodenseitigen Emitterzonen (7) in der Ebene der Oberfläche des Halbleiterkörpers (1) kreisförmig ausgebildet sind.

5. Thyristor nach einem der Ansprüche 1 - 4,
**dadurch gekennzeichnet,**
**daß** der Thyristor ein Ringthyristor ist.

6. Thyristor nach einem der Ansprüche 1 - 5
**dadurch gekennzeichnet,**
**daß** die Dotierungskonzentration der dünnen Schicht (5) sehr viel größer ist als die Dotierungskonzentrationen der kathodenseitigen Basiszone (3) und der zusätzlichen Schicht (6).

7. Thyristor nach einem der Ansprüche 1 - 6,
**dadurch gekennzeichnet,**
**daß** die anodenseitige Basiszone (29) in einer durch eine Hauptflächennormale des Halbleiterkörpers (21) definierten vertikalen Richtung eine inhomogene Verteilung der Dichte an Rekombinations- und Generationszentren freier Ladungsträger aufweist.

8. Thyristor nach Anspruch 7
**dadurch gekennzeichnet,**
**daß** die Dichte der Rekombinations- und Generationszentren innerhalb eines ersten Bereichs (36) der anodenseitigen Basiszone (29) jeweils höher ist als in den sich in vertikaler Richtung beidseitig anschließenden und jeweils bis zum benachbarten pn-Übergang erstreckenden Bereichen der anodenseitigen Basiszone (29).

9. Thyristor nach Anspruch 8
**dadurch gekennzeichnet,**
**daß** die Abmessung b des ersten Bereichs (36) in lateraler Richtung der Bedingung d_{B} < b < 2d_{B} genügt, wobei d_{B} die vertikale Dicke der anodenseitigen Basiszone (29) bezeichnet.

10. Thyristor nach Anspruch 8 oder 9,
**dadurch gekennzeichnet,**
**daß** die vertikale Lage des ersten Bereichs (36) innerhalb der anodenseitigen Basiszone (29) derart gewählt ist, daß die Raumladungszone des den beiden Basiszonen (28, 29) zugeordneten pn-Übergangs (37) den ersten Bereich (36) bei einer vorgegebenen Differenz eines Kathoden- und eines Anodenpotentials erreicht.

11. Thyristor nach Anspruch 10,
**dadurch gekennzeichnet,**
**daß** die vorgegebene Potentialdifferenz annähernd der verminderten Durchbruchspannung (U_{BOD}) entspricht.

12. Verfahren zur Herstellung eines Thyristors nach einem der Ansprüche 1 bis 11,
mit den folgende Verfahrensschritte zur Erzeugung der Rekombinationszone (9) :
- anodenseitige Maskierung des Halbleiterkörpers (1), beispileweise durch eine Metallochblende,
- anodenseitige Bestrahlung,
- abschließender Temperaturschritt zur Stabilisierung der Rekombinationszone (9).

13. Verfahren nach Anspruch 12,
**dadurch gekennzeichnet,**
**daß** die Bestrahlung des Halbleiterkörpers (1) mit nichtdotierenden, hochenergetischen Teilchen erfolgt.

14. Verfahren nach einem der Ansprüche 12 oder 13,
**dadurch gekennzeichnet,**
**daß** die Bestrahlung des Halbleiterkörpers (1) mit Protonen oder α-Teilchen erfolgt.

15. Verfahren nach einem der Ansprüche 12 bis 14,
**dadurch gekennzeichnet,**
**daß** die Dosis der durch die Bestrahlung eingebrachten Teilchen zur Erzeugung der Rekombinationszone (9) im Bereich von 10¹⁰ bis 10¹² cm⁻² bei Bestrahlung mit α-Teilchen und im Bereich von 10¹¹ bis 10¹³ cm⁻² bei Bestrahlung mit Protonen gewählt wird.

## Claims

1. Thyristor comprising a semiconductor body (1)
- having an anodal base zone (2) of the first conduction type and at least one cathodal base zone (3) of the opposite, second conduction type,
- having anodal and cathodal emitter zones (7, 8),
- having at least one region (4, 5, 6) in the cathodal base zone (3) whose geometry gives it a reduced breakdown voltage as compared with the remaining regions in the cathodal base zone (3) and the edge of the semiconductor body (1),
**characterized**
**in that**, at the anode, below the region of reduced breakdown voltage (6), at least one recombination zone (9) in which the free charge carriers have a reduced lifetime is provided, and in that the geometry of the cathodal regions (4, 5, 6) essentially has the following features:
- a cutout (4) is arranged in the central region of the cathodal base zone (3), inside which, on the surface of the semiconductor body (1), a layer (5) of the second conduction type is arranged which is thinner than the cathodal base zone (3) and is connected to the cathodal base zone (3),
- an additional zone (6) of the second conduction type is arranged in the cutout (4) and adjoins the thin layer (5),
- viewed from the cathodal base zone (3), the additional zone (6) is of concave design, at least in part.

2. The thyristor according to Claim 1,
**characterized**
**in that** the recombination zone (9) has crystal lattice defects produced by irradiation.

3. Thyristor according to Claim 2,
**characterized**
**in that** the crystal lattice defects are Frenkel defects and/or Schottky defects.

4. Thyristor according to one of Claims 1 - 3,
**characterized**
**in that** the cathodal regions (4, 5 , 6) as well as the cathodal base zone (3) and the cathodal emitter zones (7) are of circular design in the plane of the surface of the semiconductor body (1).

5. Thyristor according to one of Claims 1 - 4,
**characterized**
**in that** the thyristor is an annular thyristor.

6. Thyristor according to one of Claims 1 - 5,
**characterized**
**in that** the doping concentration of the thin layer (5) is very much higher than the doping concentration of the cathodal base zone (3) and of the additional layer (6).

7. Thyristor according to one of Claims 1 - 6,
**characterized**
**in that** the anodal base zone (29) has, in a vertical direction defined by a main surface normal to the semiconductor body (21), an inhomogeneous distribution of density at recombination and generation centres for free charge carriers.

8. Thyristor according to Claim 7,
**characterized**
**in that** the density of the recombination and generation centres within a first region (36) of the anodal base zone (29) is in each case higher than in the regions of the anodal base zone (29) which adjoin one another in a vertical direction on both sides and in each case extend as far as the adjacent pn junction.

9. Thyristor according to Claim 8,
**characterized**
**in that** the dimension b of the first region (36) satisfies the condition d_{B} < b < 2d_{B} in the lateral direction, where d_{B} denotes the vertical thickness of the anodal base zone (29).

10. Thyristor according to Claim 8 or 9,
**characterized**
**in that** the vertical position of the first region (36) within the anodal base zone (29) is chosen such that the space-charge zone of the pn junction (37) associated with the two base zones (28, 29) extends as far as the first region (36) when there is a predetermined difference between a cathode potential and an anode potential.

11. Thyristor according to Claim 10,
**characterized**
**in that** the predetermined potential difference is approximately equivalent to the reduced breakdown voltage (U_{BOD}).

12. Method of producing a thyristor according to one of Claims 1 to 11,
having the following method steps for producing the recombination zone (9):
- masking the anode of the semiconductor body (1), for example using a perforated metal screen,
- irradiation of the anode,
- a concluding heat-treatment step to stabilize the recombination zone (9).

13. Method according to Claim 12,
**characterized**
**in that** the semiconductor body (1) is irradiated with nondoping, high-energy particles.

14. Method according to one of Claims 12 and 13,
**characterized**
**in that** the semiconductor body (1) is irradiated with protons or α-particles.

15. Method according to one of Claims 12 to 14,
**characterized**
**in that** the dose of particles introduced by irradiation to produce the recombination zone (9) is chosen to be in the range from 10¹⁰ to 10¹² cm⁻² in the case of irradiation with α-particles and in the range from 10¹¹ to 10¹³ cm⁻² in the case of irradiation with protons.

## Revendications

1. Thyristor comprenant un corps semi-conducteur (1)
- avec une zone de base (2) côté anode d'un premier type de conductivité et au moins une zone de base (3) côté cathode d'un deuxième type de conductivité, opposée,
- avec des zones d'émetteur (7, 8) côté anode et côté cathode,
- avec au moins une zone (4, 5, 6) dans la zone de base (3) côté cathode qui, par sa géométrie, présente une tension de claquage réduite par rapport aux autres zones dans la zone de base (3) côté cathode et au bord du corps semi-conducteur (1),
**caractérisé en ce que**
côté anode, sous la zone à tension de claquage réduite (6), au moins une zone de recombinaison (9) d'une durée de vie réduite des porteurs de charge libres est prévue, et la géométrie des zones côté cathode (4, 5, 6) présente pour l'essentiel les caractéristiques suivantes :
- un évidement (4) située dans la zone centrale de la zone de base (3) côté cathode, à l'intérieur duquel est disposée, à la surface du corps semi-conducteur (1), une couche (5) du deuxième type de conductivité plus mince que la zone de base (3) côté cathode, qui est reliée à la zone de base (3) côté cathode,
- dans l'évidement (4) une zone supplémentaire (6) du deuxième type de conductivité est disposée de manière adjacente à la couche mince (5), et
- vue depuis la zone de base (3) côté cathode, la zone supplémentaire (6) présente une forme du moins partiellement concave.

2. Thyristor selon la revendication 1,
**caractérisé en ce que**
la zone de recombinaison (9) présente des défauts du réseau cristallin générés par exposition aux rayons.

3. Thyristor selon la revendication 2,
**caractérisé en ce que**
les défauts du réseau cristallin sont des défauts de Frenkel et/ou des défauts de Schottky.

4. Thyristor selon l'une quelconque des revendications 1 - 3,
**caractérisé en ce que**
les zones (4, 5, 6) côté cathode ainsi que la zone de base côté cathode (3) et les zones d'émetteur (7) côté cathode sont formées circulaires dans le plan de la surface du corps semi-conducteur (1).

5. Thyristor selon l'une quelconque des revendications 1 - 4,
**caractérisé en ce que**
le thyristor est un thyristor annulaire.

6. Thyristor selon l'une quelconque des revendications 1 - 5,
**caractérisé en ce que**
la concentration de dopage de la couche mince (5) est beaucoup plus grande que les concentrations de dopage de la zone de base (3) côté cathode et de la couche supplémentaire (6).

7. Thyristor selon l'une quelconque des revendications 1 - 6,
**caractérisé en ce que**
la zone de base (29) côté anode présente, dans une direction verticale définie par une normale de surface principale du corps semi-conducteur (21), une répartition non-homogène de la densité de centres de recombinaison et de génération de porteurs de charge libres.

8. Thyristor selon la revendication 7,
**caractérisé en ce que**
la densité des centres de recombinaison et de génération est respectivement plus grande à l'intérieur d'une première zone (36) de la zone de base (29) côté anode, qu'à l'intérieur des zones de la zone de base (29) côté anode s'étendant de part et d'autre en direction verticale et respectivement jusqu'au passage pn voisin.

9. Thyristor selon la revendication 8,
**caractérisé en ce que**
la cote b de la première zone (36) en direction latérale suffit à la condition d_{B} < b < 2d_{B}, d_{B} désignant l'épaisseur verticale de la zone de base (29) côté anode.

10. Thyristor selon la revendication 8 ou 9,
**caractérisé en ce que**
la position verticale de la première zone (36) à l'intérieur de la zone de base (29) côté anode est choisie telle que la zone de charge d'espace du passage pn (37) associé aux deux zones de base (28, 29) atteint la première zone (36) à une différence prédéterminée d'un potentiel cathodique et d'un potentiel anodique.

11. Thyristor selon la revendication 10,
**caractérisé en ce que**
la différence de potentiels prédéterminée correspond sensiblement à la tension de claquage (U_{BOD}) réduite.

12. Procédé de fabrication d'un thyristor selon l'une quelconque des revendications 1 à 11, comprenant les étapes de procédé suivantes pour obtenir la zone de recombinaison (9) :
- masquage côté anode du corps semi-conducteur (1), par exemple à l'aide d'un écran métallique perforé,
- exposition aux rayons côté anode,
- étape de température finale pour stabiliser la zone de recombinaison (9).

13. Procédé selon la revendication 12,
**caractérisé en ce que**
le corps semi-conducteur (1) est exposé aux rayons de particules non dopées hautement énergétiques.

14. Procédé selon l'une quelconque des revendications 12 ou 13,
**caractérisé en ce que**
le corps semi-conducteur (1) est exposé aux rayons de protons ou de particules (α).

15. Procédé selon l'une quelconque des revendications 12 à 14,
**caractérisé en ce que**
la dose de particules introduites pour l'exposition aux rayons pour générer la zone de recombinaison (9) se situe dans la plage de 10¹⁰ à 10¹² cm⁻² environ pour une exposition aux rayons de particules (α), et de 10¹¹ à 10¹³ cm⁻² pour une exposition aux rayons de protons.
